# EUROPÄISCHE PATENTSCHRIFT

(11) **EP 2 622 972 B1**
(45) Veröffentlichungstag und Bekanntmachung des Hinweises auf die Patenterteilung: **20.05.2015**
(21) Anmeldenummer: 13153170.9
(22) Anmeldetag: 30.01.2013
(51) Int. Cl.: A24C 5/28

(54) **Vorrichtung zum Führen und Halten eines in Transportrichtung T kontinuierlich geförderten Strangs der Tabak verarbeitenden Industrie sowie Tubenradsatz**
Apparatus for guiding and holding a rod of the tobacco industry continuously conveyed in transport direction T and a tube wheel set
Dispositif de transport et de support d'un tronçon de l'industrie de traitement du tabac alimenté en continudans une direction de transport T ainsi que jeu de rues de tube

(30) Priorität: 31.01.2012 DE 102012100757
(43) Veröffentlichungstag der Anmeldung: 07.08.2013
(73) Patentinhaber: HAUNI Maschinenbau AG, 21033 Hamburg (DE)
(72) Erfinder: Roßfeldt, Niko, 21465 Wentorf (DE)
(74) Vertreter: Stork Bamberger

(56) Entgegenhaltungen:
- EP-A1- 1 815 757
- EP-A2- 1 905 316
- EP-A2- 2 092 839
- EP-A2- 2 106 707
- DE-A1-102006 016 729

## Beschreibung

Die Erfindung betrifft eine Vorrichtung zum Führen und Halten mindestens eines in Transportrichtung T kontinuierlich geförderten Strangs der Tabak verarbeitenden Industrie während eines Schneidvorgangs strangförmiger Artikel von dem oder jedem Strang, umfassend ein mittels eines Antriebs antreibbares Tubenrad, das aus einem Antriebskörper und einem Führungskörper gebildet ist, die über mindestens ein Koppelelement, dem mindestens eine Tube als Halte- und Führungselement zugeordnet ist, miteinander in Wirkverbindung stehen, wobei der Antriebskörper mit einer Antriebswelle des Antriebs verbunden ist, derart, dass der Antriebskörper um die Rotationsachse A als ortsfeste und verstellfreie Antriebsachse rotierend angetrieben ist, und der Führungskörper an einem Tragarm auf einem Achselement gelagert ist, derart, dass der Führungskörper um eine Rotationsachse B, die versetzt zur Rotationsachse A angeordnet ist, rotierend ausgebildet ist, wobei ein Tubenrad zur Anpassung der Vorrichtung an veränderte, das Format bestimmende Artikellängen gegen ein anderes Tubenrad austauschbar ist.

Die Erfindung befasst sich auch mit einem Tubenradsatz zum Führen und Halten mindestens eines in Transportrichtung T kontinuierlich geförderten Strangs der Tabak verarbeitenden Industrie während eines Schneidvorgangs strangförmiger Artikel unterschiedlicher Formate von dem oder jedem Strang, umfassend mindestens zwei um eine bezüglich des Abstandes H zum Strang konstante, nämlich ortsfeste und verstellfreie Antriebsachse rotierend antreibbare Tubenräder unterschiedlicher Geometrie, wobei die Tubenräder unterschiedlicher Geometrie jeweils einen Antriebskörper und einen Führungskörper aufweisen, die durch mindestens ein Koppelelement miteinander in Wirkverbindung stehen.

Solche Vorrichtungen kommen in der Tabak verarbeitenden Industrie zum Einsatz. Üblicherweise sind solche Vorrichtungen in einer Strangmaschine angeordnet oder dieser zugeordnet. Der Strangmaschine ist des Weiteren eine Schneideinrichtung zugeordnet, die einen rotierend angetriebenen Messerträger umfasst. An der Umfangsfläche des Messerträgers sind Messer angeordnet, die queraxial zu dem oder jedem zu schneidenden Strang ausgerichtet auf diesen treffen und somit einzelne strangförmige Artikel von dem oder jedem Strang schneiden. Die gattungsgemäße Vorrichtung dient mit ihren Tuben dabei als Schnittgegenlage beispielsweise beim Trennen von Tabakstöcken von einem oder mehreren in einer Strangmaschine produzierten Tabaksträngen oder beim Trennen von Filterstäben einfacher oder mehrfacher Gebrauchslänge von einem Filterstrang. Dazu läuft das Tubenrad ebenfalls rotierend um. An dem Tubenrad ist mindestens eine Tube als Halte- und Führungselement angeordnet. Das Tubenrad ist derart auf den oder jeden Strang sowie den Messerträger eingestellt, dass jeweils eine Tube des Tubenrades und ein Messer des Messerträgers zeitgleich und synchron auf den Strang treffen. Anders ausgerückt befindet sich stets eine an die Kontur des Strangs angepasste Tube als Gegenlage auf der dem Messer gegenüber liegenden Seite des Strangs und umgibt diesen teilweise, um den Strang beim Schneiden zu halten und zu führen. Um eine Kollision des Messers mit der Tube zu verhindern, weist jede Tube einen Schlitz auf, der geringfügig breiter als das Messer ist, so dass das Messer durch den Strang und die den Strang haltende Tube bewegt werden kann. Die stabförmigen Artikel, die von einem oder mehreren parallel geführten Strängen abgetrennt werden, können aber auch Zigaretten, Filter, Filtersegmente, Segmentgruppen oder dergleichen sein. Die Länge der von dem Strang abgetrennten Artikel wird im Folgenden als Formatlänge (in Kurzform Format) bezeichnet.

Bei der Produktion der vorgenannten Artikel kommt es häufig vor, dass ein Formatwechsel notwendig ist. Das bedeutet, dass die Produktion von einer ersten Länge der Artikel auf eine zweite, von der ersten Länge abweichende Länge umgestellt werden muss. Die Umstellung der Strangmaschine auf ein anderes Format macht eine Veränderung der Geometrie des Tubenrades bzw. eine Veränderung der durch die Tuben beschriebenen Umlaufbahn erforderlich, weshalb in jedem Fall die gattungsgemäße Vorrichtung bei einem Formatwechsel ausgetauscht wird. Durch die Veränderung der Geometrie des Tubenrades und der damit verbundenen Veränderung der Umlaufbahn bzw. des Laufkreises K der Tuben entsteht zwischen den Tuben und dem Strang ein Abstand, den es auszugleichen gilt, damit die Tuben beim Schneiden wieder am Strang anliegen.

Zum Ausgleich des durch die unterschiedlichen Geometrien der Tubenräder entstehenden Abstandes ist es bekannt, die Position des Mittelpunktes des Tubenrades, also den Abstand zwischen der Antriebsachse des Tubenrades und dem zu schneidenden Strang, zu verstellen bzw. an die geänderte Geometrie anzupassen. Diese Vorrichtungen sind aufgrund des notwendigen, aus Antrieb und Getriebe gebildeten Stellmechanismus konstruktiv aufwendig und erfordern wegen der Veränderung der Phasenlage zwischen dem Tubenrad und dem Messerträger einen erheblichen und schwierigen Nachstellaufwand.

Aus der EP 2 106 707 A2 ist eine Vorrichtung bekannt, die, bezogen auf die Position des Tubenrades, als verstellfreie Wechselvorrichtung ausgebildet ist. Die Anpassung der Vorrichtung an ein geändertes Format, also der Ausgleich der durch die geänderte Geometrie der Tubenräder entstehenden Differenz im Abstand der Tuben zum Strang wird durch die veränderte Länge der Tuben ausgeglichen. Mit anderen Worten werden die Tuben bei kleinen Geometrien verlängert und bei großen Geometrien verkürzt. Diese Lösung ist jedoch insbesondere dann instabil, wenn die Tuben eine große Länge aufweisen. Wie erwähnt, sind die Tuben an Koppelelementen angeordnet, die ihrerseits sowohl im Antriebskörper als auch im Führungskörper gelagert sind. Jedes Lager weist ein Lagerspiel auf. Dieses Lagerspiel verstärkt sich, je länger der durch die Tube gebildete Hebel ist. Die Genauigkeit der Einstellung der Tube in Bezug auf das Messer ist bei zunehmendem Lagerspiel nicht mehr gegeben. Anders ausgedrückt ist die exakte Position/Lage des Schlitzes in der Tube in Bezug auf die Trennmesser bei größer werdendem Lagerspiel sowie der zunehmenden Länge der Tuben nicht mehr gewährleistet, so dass es zu Kollisionen zwischen den Trennmessern und den Tuben kommen kann.

Der Erfindung liegt daher die Aufgabe zugrunde, eine einfache und kompakte Vorrichtung zu schaffen, die eine schnelle und präzise Umstellung auf ein anderes Format gewährleistet. Der Erfindung liegt des Weiteren die Aufgabe zugrunde, einen entsprechenden Tubenradsatz vorzuschlagen.

Diese Aufgabe wird durch eine Vorrichtung der eingangs genannten Art dadurch gelöst, dass das oder jedes Koppelelement als Formatteil ausgebildet ist, derart, dass die Länge des oder jedes Koppelelementes an das jeweils zu schneidende Format angepasst ist, so dass die austauschbaren Tubenräder unterschiedlicher Geometrien bei identischer Länge der Tuben einen konstanten Abstand H zwischen der Rotationsachse A und dem zu schneidenden Strang aufweisen. Mit dieser Ausbildung, bei der neben dem Tragarm, dem Antriebskörper und dem Führungskörper erfindungsgemäß auch das oder jedes Koppelelement als Formatteil ausgebildet ist, wird eine schnelle und präzise Umstellung von Tubenrad zu Tubenrad sichergestellt. Dadurch, dass die Tuben für alle Tubenräder unabhängig von der Geometrie, also unabhängig von der Größe bzw. dem Durchmesser der Tubenräder, gleich sind, wird der Einfluss des Lagerspiels reduziert. Anders ausgedrückt ermöglicht die Erfindung, dass die Präzision bzw. Genauigkeit für das Tubenrad direkt aus dem Gestell, an dem die Vorrichtung befestigt ist, kommt bzw. durch dieses bestimmt wird und nicht von der Größe bzw. Länge der Tuben abhängt. Der Begriff "Formatteil" bedeutet in diesem Zusammenhang nicht nur, dass es sich um ein Austauschteil handelt, sondern insbesondere auch, dass das oder jedes Formatteil individuell dem Format der zu schneidenden Artikel angepasst ist. Mit anderen Worten ist das oder jedes Formatteil von Tubenrad zu Tubenrad in der Größe variierend.

Zweckmäßigerweise ist das oder jedes Koppelelement etwa Z-förmig ausgebildet, wobei die Länge eines Ausgleichschenkels des Koppelelementes formatabhängig ist. Besonders bevorzugt variiert die Länge des Ausgleichschenkels des oder jedes Koppelelementes mit der Veränderung der Geometrie der Tubenräder. Durch diese Ausbildung ist die Anpassung der Koppelelemente an unterschiedliche Formate besonders einfach und effektiv. Eine Vergrößerung der Größe/des Durchmesser des Tubenrads wird durch eine Verkürzung des Ausgleichschenkels ausgeglichen. Eine Reduzierung der Größe/des Durchmessers des Tubenrads wird durch eine Verlängerung des Ausgleichschenkels ausgeglichen. Dabei bleiben die Tuben unverändert. Mit anderen Worten variiert die Länge des Ausgleichschenkels um den Betrag, um den der Radius der Tubenräder verändert wird.

Vorteilhafterweise ist sowohl der Antriebskörper als auch der Führungskörper als scheibenartiger Rotationskörper ausgebildet, wobei die Geometrie der Tubenräder über die Radien der Rotationskörper definiert ist. Als scheibenartig werden u.a. sowohl solche Rotationskörper betrachtet, die die Form einer Kreisscheibe aufweisen, als auch solche Rotationskörper, die mehrere radial gerichtete Arme aufweisen. In allen Fällen beschreiben die an den Tubenrädern angeordneten Tuben eine Umlaufbahn bzw. einen Laufkreis K. Vereinfacht ausgedrückt bedeuten ein kleiner Laufkreis eine kleine Geometrie/einen kleinen Durchmesser von Antriebskörper und Führungskörper und ein großer Laufkreis eine große Geometrie/einen großen Durchmesser von Antriebskörper und Führungskörper. Diese konstruktive Ausführung vereinfacht die Anpassung an unterschiedliche Formate und gewährleistet die notwendige Stabilität der Vorrichtung. Des Weiteren ermöglicht diese Ausbildung eine sehr kompakte Konstruktion der Vorrichtung.

Vorzugsweise sind die Radien der beiden das Tubenrad bildenden Rotationskörper für jedes Format identisch, von Format zu Format jedoch variierend, wobei die sich daraus ergebende Differenz Δ h durch die angepasste Länge des Ausgleichschenkels von dem oder jedem Koppelelement ausgleichbar ist. Die gleichen Durchmesser bzw. Radien der Rotationskörper untereinander eines Tubenrades für ein erstes Format führen dazu, dass sich bei einem Wechsel der Tubenräder auf ein anderes Format, bei dem die Durchmesser bzw. Radien der Rotationskörper untereinander wiederum gleich sind, lediglich der Abstand der zwischen den Rotationsachsen A und B verändert, der durch die unterschiedlich langen Ausgleichschenkel des Koppelelementes ausgeglichen wird. Dieser Abstand Δ h wird allein durch die Veränderung der Position der Rotationsachse B des Führungskörpers bestimmt, da die Position der Rotationsachse A des Antriebskörpers fix und unverändert ist.

Besonders bevorzugt ist eine Ausführungsform, bei der ein Lagerschenkel des Koppelelementes in dem Antriebskörper gelagert ist, während ein anderer Lagerschenkel des Koppelelementes im Führungskörper gelagert ist, wobei der im Führungskörper gelagerte Lagerschenkel mindestens eine Tube trägt. Dadurch werden eine besonders hohe Stabilität und ein enger Bauraum geschaffen. Durch die erfindungsgemäße Ausbildung wird insgesamt eine kompakte Bauweise erzielt, wodurch für andere Komponenten, beispielsweise eine Schleifscheibe für die Schneidmesser, zusätzlicher Bauraum geschaffen wird.

Die Aufgabe wird auch durch einen Tubenradsatz mit den eingangs genannten Merkmalen dadurch gelöst, dass die Koppelelemente der Tubenräder unterschiedlicher Geometrie in der Größe voneinander abweichen. Die sich daraus ergebenden Vorteile wurden bereits im Zusammenhang mit der Vorrichtung beschrieben, weshalb zur Vermeidung von Wiederholungen auf die entsprechenden Passagen verwiesen wird.

Weitere zweckmäßige und/oder vorteilhafte Merkmale und Weiterbildung ergeben sich aus den Unteransprüchen und der Beschreibung. Eine besonders bevorzugte Ausführungsform wird anhand der beigefügten Zeichnung näher erläutert. In der Zeichnung zeigt:
- Fig. 1: eine stark schematisierte Darstellung einer Vorrichtung mit einem Tubenrad einer ersten Geometrie,
- Fig. 2: eine stark schematisierte Darstellung einer Vorrichtung mit einem Tubenrad einer zweiten, von der ersten Geometrie abweichenden Geometrie,
- Fig. 3: eine weitere schematische Darstellung der Vorrichtung gemäß Figur 1, wobei der Tragarm und der Antriebs aus Gründen der Übersichtlichkeit weggelassen wurden,
- Fig. 4: eine weitere schematische Darstellung der Vorrichtung gemäß Figur 2, wobei der Tragarm und der Antriebs aus Gründen der Übersichtlichkeit weggelassen wurden,
- Fig. 5: eine perspektivische Darstellung der Vorrichtung gemäß Figur 3,
- Fig. 6: eine perspektivische Darstellung der Vorrichtung gemäß Figur 4, und

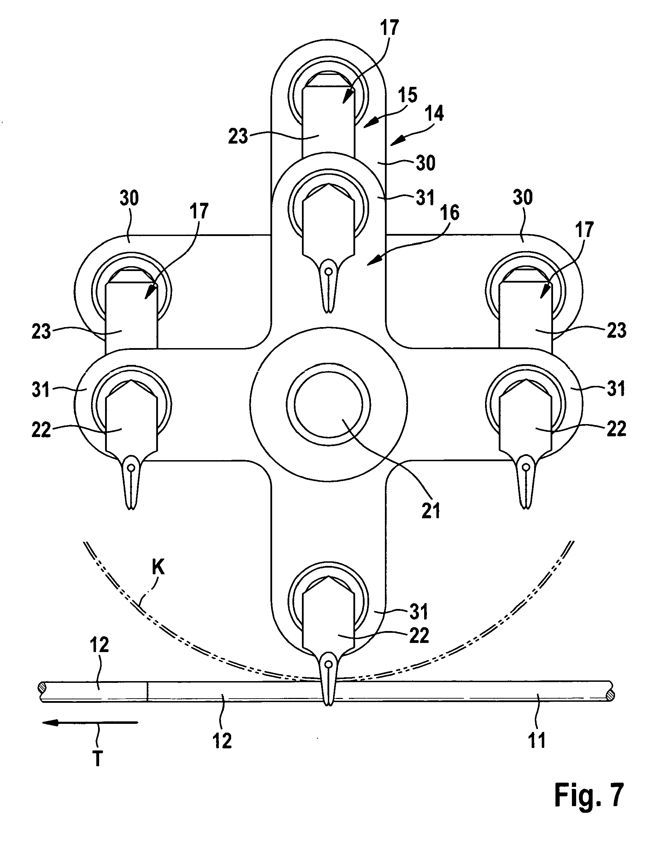

- Fig. 7: eine schematische Darstellung der Vorrichtung gemäß Figur 5 in Vorderansicht.

Die in der Zeichnung dargestellte Vorrichtung zum Führen und Halten mindestens eines in Transportrichtung T kontinuierlich geförderten Strangs der Tabak verarbeitenden Industrie während eines Schneidvorgangs strangförmiger Artikel von dem oder jedem Strang dient als Schnittgegenlage in einer Tabak-Strangmaschine. Selbstverständlich kann die Vorrichtung auch als Schnittgegenlage in einer Filter-Strangmaschine oder in anderen Maschinen der Tabak verarbeitenden Industrie, in denen stabförmige Artikel von einem Strang getrennt werden, eingesetzt werden. Das erfindungsgemäße Prinzip ist letztlich auch in Vorrichtungen zur Übergabe der stabförmigen Artikel von einer Vorrichtung zur queraxialen Förderung der Artikel auf eine Vorrichtung zur längsaxialen Förderung der Artikel oder umgekehrt einsetzbar.

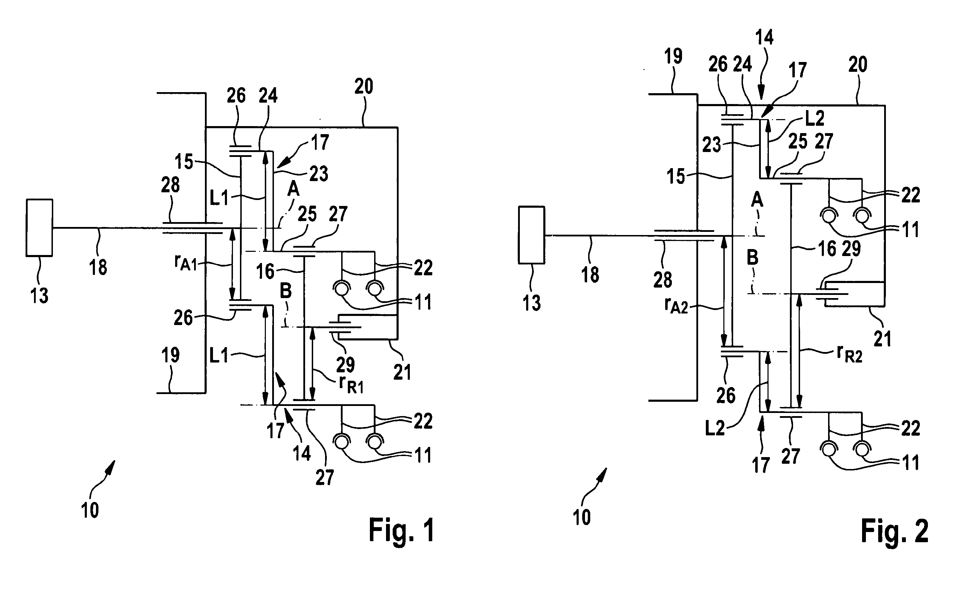

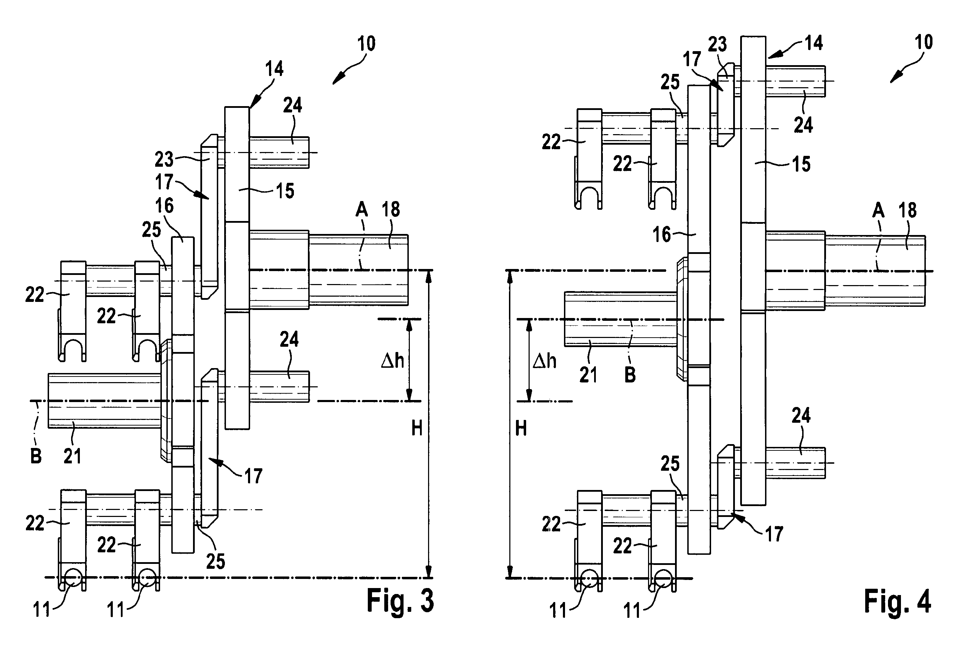

Die in den Figuren 1 und 2 äußerst schematisch und nicht maßstabsgetreu dargestellte Vorrichtung 10 zum Führen und Halten mindestens eines in Transportrichtung T kontinuierlich geförderten Strangs 11 der Tabak verarbeitenden Industrie während eines Schneidvorgangs strangförmiger Artikel 12 von dem oder jedem Strang 11 umfasst einen Antrieb 13 zum rotierenden Antreiben eines Tubenrades 14. Das Tubenrad 14 ist aus einem Antriebskörper 15 und einem Führungskörper 16 gebildet. Der Antriebskörper 15 und der Führungskörper 16 stehen über mindestens ein Koppelelement 17, dem mindestens eine Tube 22 als Halte- und Führungselement zugeordnet ist, in Wirkverbindung miteinander. Der Antriebskörper 15 ist mit einer Antriebswelle 18 mit dem Antrieb 13 verbunden, derart, dass der Antriebskörper 15 um die Rotationsachse A rotierend angetrieben ist. Die Rotationsachse A ist ortsfest und verstellfrei in einem Lager 28 an einem Rahmen 19, in einem Gehäuse, an einem Gestell oder dergleichen einer Strangmaschine gelagert. Das bedeutet, dass die Rotationsachse A für jedes Format unabhängig von der Geometrie der Tubenräder 14 stets an identischer Position und mit identischem Abstand H (siehe z.B. Figuren 3 und 4) zu dem oder jedem zu schneidenden Strang 11 steht. Der Führungskörper 16 ist in einem Lager 29 an einem Tragarm 20 auf einem Achselement 21 gelagert, derart, dass der Führungskörper 16 um eine Rotationsachse B rotierend ausgebildet ist. Der Antriebskörper 15 ist also aktiv angetrieben, während der Führungskörper 16 über die Wirkverbindung des oder jedes Koppelelementes 17 von dem Antriebskörper 15 "mitgenommen" wird.

Die Rotationsachsen A und B sind versetzt zueinander angeordnet. Sie verlaufen parallel und gleichgerichtet zueinander in unterschiedlichen horizontalen Ebenen. Der Tragarm 20 selbst ist fest mit dem Rahmen 19 oder dergleichen verbunden. Sowohl der Tragarm 20 als auch das Tubenrad 14, also der Antriebskörper 15 und der Führungskörper 16, sind so genannte Formatteile, die entsprechend des zu schneidenden Formats der Artikel 12 in ihren Geometrien bzw. Abmessungen individuell auf das jeweilige Format abgestimmt sind. Bei einem Formatwechsel in einer Strangmaschine muss das passende Tubenrad 14 eingesetzt werden, weshalb das Tubenrad 14 zur Anpassung der Vorrichtung 10 an veränderte, das Format bestimmende Artikellängen gegen ein anderes Tubenrad 14 austauschbar ist. Bevorzugt erfolgt jedoch ein Austausch der gesamten Vorrichtung 10 mit entsprechend angepassten Formatteilen.

Erfindungsgemäß ist das oder jedes Koppelelement 17 als Formatteil ausgebildet, derart, dass die Länge des oder jedes Koppelelementes 17 an das jeweils zu schneidende Format angepasst ist, so dass die austauschbaren Tubenräder 14 unterschiedlicher Geometrien bei identischer Länge der Tuben 22 einen konstanten Abstand H zwischen der Antriebsachse A und dem zu schneidenden Strang 11 aufweisen. Mit anderen Worten wird die durch die unterschiedlichen Geometrien der Tubenräder 14 bzw. genauer durch die Radiusveränderung von Antriebskörper 15 und Führungskörper 16 und die damit einhergehende Positionsveränderung der Rotationsachse B entstehende Differenz Δ h (siehe z.B. Figuren 3 und 4) durch die Größe bzw. Geometrie des oder jedes Koppelelementes 17 ausgeglichen.

Die im Folgenden beschriebenen Merkmale und Weiterbildungen stellen für sich betrachtet oder in Kombination miteinander bevorzugte Ausführungsformen der Erfindung dar.

Das oder jedes Koppelelement 17 ist etwa Z-förmig ausgebildet, wobei die Länge eines Ausgleichsschenkels 23 des Koppelelementes 17 formatabhängig ist. Anders ausgedrückt umfasst jedes Koppelelement 17 einen Ausgleichschenkel 23, wobei an den entgegen gesetzten Enden des Ausgleichschenkels 23 jeweils ein Lagerschenkel 24, 25 angeordnet ist. In montiertem Zustand des Koppelelementes 17 verläuft der Ausgleichschenkel 23 vertikal zu den Rotationsachsen A und B, während die Lagerschenkel 24, 25 parallel zu den und in Richtung der Rotationsachsen A und B verlaufen. Bevorzugt ist das Koppelelement 17 einstückig ausgebildet. In der gezeigten Ausführungsform sind vier Koppelelemente 17 vorgesehen. Die Anzahl der Koppelelemente 17 kann jedoch variieren. Einer der Lagerschenkel 24 ist im Antriebskörper 15 in einem Lager 26 gelagert, während der andere Lagerschenkel 25 im Führungskörper 16 in einem Lager 27 gelagert ist. An dem im Führungskörper 16 gelagerten Lagerschenkel 25 ist an dem freien Ende, das auf der dem Antriebskörper 15 abgewandten Seite aus dem Führungskörper 16 herausragt, mindestens eine Tube 22 angeordnet. In Abhängigkeit der Anzahl der in einer Strangmaschine produzierten und zu schneidenden Stränge 11 kann die Anzahl der Tuben 22 auch variieren. In der gezeigten Ausführungsform sind jedem Koppelelement 17 zwei Tuben 22 zugeordnet, deren Aufbau und Konstruktion hinlänglich bekannt sind, weshalb auf eine detaillierte Beschreibung verzichtet wird. Mehrere Tuben 22 sind bezogen auf den Lagerschenkel 25 axial versetzt nebeneinander angeordnet, und zwar im Abstand der Stränge 11 innerhalb der Strangmaschine. Die Länge L jedes Ausgleichsschenkels 23 eines Koppelelementes 23 variiert mit der Veränderung der Geometrie der Tubenräder 14. In der Figur 1 weisen die Ausgleichsschenkel 23 eine Länge L1 auf, während die Ausgleichsschenkel 23 in der Figur 2 eine Länge L2 aufweisen, wobei L1 größer L2. Entsprechend ist die Geometrie des Tubenrades 14 in der Figur 1 kleiner als in der Figur 2.

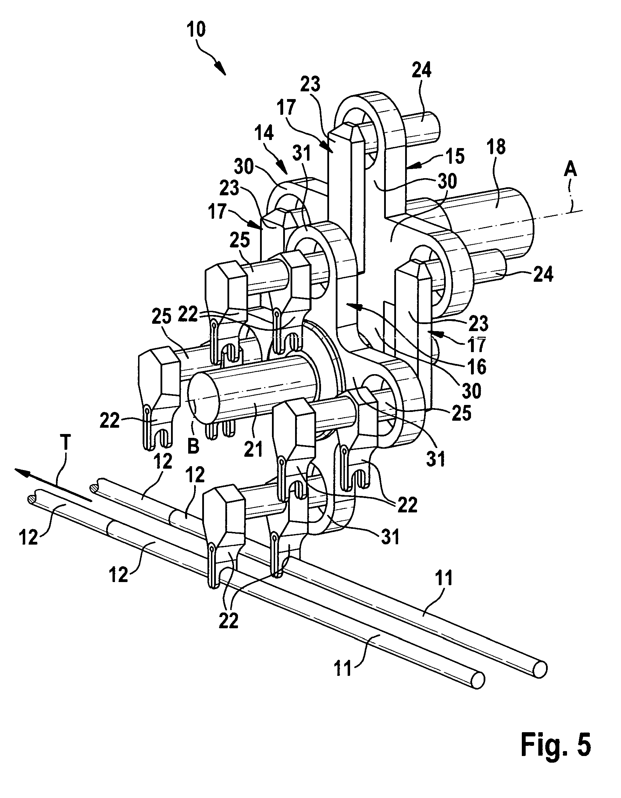

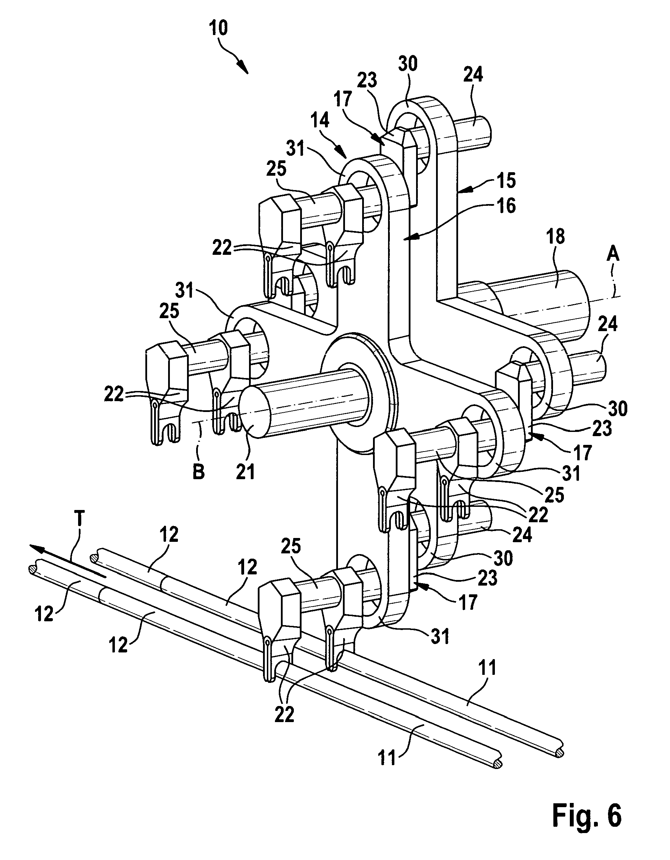

Wie insbesondere den Figuren 3 bis 6 zu entnehmen, ist sowohl der Antriebskörper 15 als auch der Führungskörper 16 als scheibenartiger Rotationskörper ausgebildet, wobei die Geometrie der Tubenräder 14 über die Durchmesser bzw. die Radien der Rotationskörper definiert ist. Mit anderen Worten spricht man von einer kleiner werdenden Geometrie des Tubenrades 14, wenn der Radius r_{A} von Antriebskörper 15 und r_{R} von Führungskörper 16 reduziert werden, und entsprechend von einer größer werdenden Geometrie, wenn der Radius r_{A} von Antriebskörper 15 und r_{R} Rotationskörper 16 vergrößert werden. In der gezeigten Ausführungsform weisen der Antriebskörper 15 und der Führungskörper 16 einem Propeller ähnlich mehrere Arme 30 bzw. 31 auf. Die Anzahl der Arme 30, 31 und damit die Anzahl der Koppelelemente 17 kann aber variieren. In jedem der Arme 30, 31 ist im Bereich des freien Endes das Lager 26, 27 ausgebildet bzw. angeordnet. Die Lager 26, 27 sind konzentrisch um die jeweilige Rotationsachse A bzw. B angeordnet. In weiteren Ausführungsformen können die Rotationskörper auch Kreisscheiben oder aus anderen Rotationselementen unterschiedlicher Gestalt gebildet sein.

Die Radien r_{A} und r_{R} der beiden das Tubenrad 14 bildenden Rotationskörper sind für jedes Format identisch, nämlich beispielsweise r_{A1} gleich r_{R1} und r_{A2} gleich r_{R2}, von Format zu Format jedoch variierend, nämlich r_{A1} ungleich r_{A2} und r_{R1} ungleich r_{R2}, wobei die sich daraus ergebende Differenz von Δ h durch die angepasste Länge des Ausgleichschenkels 23 von dem oder jedem Koppelelement 17 ausgleichbar ist. Anders ausgedrückt verändert sich bei einer Änderung der Radien r_{A} und r_{R} zwangsläufig die Position der Rotationsachse B in Bezug auf die Rotationsachse A und damit auch zum Strang 11. Die durch die umlaufenden Tuben 22 beschriebene Umlaufbahn bzw. der Laufkreis K ändert sich durch die Veränderung der Geometrie des Tubenrades 14, so dass bei veränderter Tubenradgröße die Differenz Δ h in der Höhe der Rotationsachse B zum Strang 11 ausgeglichen werden, was durch die erfindungsgemäße Formatabhängigkeit der Koppelelemente 17 erfolgt.

Mindestens zwei der zuvor beschriebenen Tubenräder 14 unterschiedlicher Größe bilden einen Tubenradsatz, wie er in den Figuren 3 und 4 dargestellt ist. Die Tubenräder 14 eines Tubenradsatzes weisen unterschiedliche Durchmesser auf. Das bedeutet, dass z.B. ein erstes Tubenrad 14 (siehe Figur 3) des Tubenradsatzes einen kleineren Durchmesser aufweist als ein zweites Tubenrad 14 (siehe Figur 4). Die sich daraus ergebenden Unterschiede im Laufkreis K werden durch die unterschiedlichen Längen der Koppelelemente 17 und genauer durch die in der Länge an das jeweilige Format angepassten Ausgleichschenkel 23 der Koppelelemente 17 ausgeglichen. Damit berühren sich die Laufkreise K der Tubenräder 14 bzw. der Tuben 22 bei der Montage auf derselben, in der Position unveränderten Antriebswelle exakt in dem Bereich, in dem die Trennmesser der Schneidvorrichtung auf den Strang 11 treffen, also in dem Bereich, in dem der Trennvorgang erfolgt.

Bevorzugt werden mindestens zwei Vorrichtungen 10 als vollständige Montageeinheiten bereit gehalten, wobei jede der Vorrichtungen 10 auf ein definiertes Format der zu schneidenden Artikel abgestimmt ist. Die Anpassung der Vorrichtung 10 an die unterschiedlichen Formate wird mittels der formatabhängigen Koppelelemente 17 erreicht. Neben den ohnehin formatabhängigen Komponenten der Vorrichtung 10, nämlich Antriebskörper 15, Führungskörper 16 sowie Tragarm 20, ist erfindungsgemäß auch jedes Koppelelement 17 formatabhängig, wohingegen die Tuben 22 in ihrer Größe/Länge für alle Vorrichtungen 10 unabhängig von deren Format gleichbleibend sind.

## Patentansprüche

1. Vorrichtung (10) zum Führen und Halten mindestens eines in Transportrichtung T kontinuierlich geförderten Strangs (11) der Tabak verarbeitenden Industrie während eines Schneidvorgangs strangförmiger Artikel (12) von dem oder jedem Strang (11), umfassend ein mittels eines Antriebs (13) antreibbares Tubenrad (14), das aus einem Antriebskörper (15) und einem Führungskörper (16) gebildet ist, die über mindestens ein Koppelelement (17), dem mindestens eine Tube (22) als Halte- und Führungselement zugeordnet ist, miteinander in Wirkverbindung stehen, wobei der Antriebskörper (15) mit einer Antriebswelle (18) des Antriebs (13) verbunden ist, derart, dass der Antriebskörper (15) um die Rotationsachse A als ortsfeste und verstellfreie Antriebsachse rotierend angetrieben ist, und der Führungskörper (16) an einem Tragarm (20) auf einem Achselement (21) gelagert ist, derart, dass der Führungskörper (16) um eine Rotationsachse B, die versetzt zur Rotationsachse A angeordnet ist, rotierend ausgebildet ist, wobei ein Tubenrad (14) zur Anpassung der Vorrichtung (10) an veränderte, das Format bestimmende Artikellängen gegen ein anderes Tubenrad (14) austauschbar ist, **dadurch gekennzeichnet, dass** das oder jedes Koppelelement (17) als Formatteil ausgebildet ist, derart, dass die Länge des oder jedes Koppelelementes (17) an das jeweils zu schneidende Format angepasst ist, so dass die austauschbaren Tubenräder (14) unterschiedlicher Geometrien bei identischer Länge der Tuben (22) einen konstanten Abstand H zwischen der Rotationsachse A und dem zu schneidenden Strang (11) aufweisen.

2. Vorrichtung nach Anspruch 1, **dadurch gekennzeichnet, dass** das oder jedes Koppelelement (17) etwa Z-förmig ausgebildet ist, wobei die Länge eines Ausgleichsschenkels (23) des Koppelelementes (17) formatabhängig ist.

3. Vorrichtung nach Anspruch 2, **dadurch gekennzeichnet, dass** die Länge des Ausgleichsschenkels (23) des oder jedes Koppelelementes (17) mit der Veränderung der der Geometrie der Tubenräder (14) variiert.

4. Vorrichtung nach einem der Ansprüche 1 bis 3, **dadurch gekennzeichnet, dass** sowohl der Antriebskörper (15) als auch der Führungskörper (16) als scheibenartiger Rotationskörper ausgebildet ist, wobei die Geometrie der Tubenräder (14) über die Radien der Rotationskörper definiert ist.

5. Vorrichtung nach Anspruch 4, **dadurch gekennzeichnet, dass** die Radien der beiden das Tubenrad (14) bildenden Rotationskörper für jedes Format identisch sind, von Format zu Format jedoch variierend, wobei die sich daraus ergebende Differenz Δ h durch die angepasste Länge des Ausgleichschenkels (23) von dem oder jedem Koppelelement (17) ausgleichbar ist.

6. Vorrichtung nach einem der Ansprüche 1 bis 5, **dadurch gekennzeichnet, dass** ein Lagerschenkel (24) des Koppelelementes (17) in dem Antriebskörper (15) gelagert ist, während ein anderer Lagerschenkel (25) des Koppelelementes (17) im Führungskörper (16) gelagert ist, wobei der im Führungskörper (16) gelagerte Lagerschenkel (25) mindestens eine Tube (22) trägt.

7. Tubenradsatz zum Führen und Halten mindestens eines in Transportrichtung T kontinuierlich geförderten Strangs (11) der Tabak verarbeitenden Industrie während eines Schneidvorgangs strangförmiger Artikel (12) unterschiedlicher Formate von dem oder jedem Strang (11), umfassend mindestens zwei um eine bezüglich des Abstandes H zum Strang (11) konstante, nämlich ortsfeste und verstellfreie Antriebsachse rotierend antreibbare Tubenräder (14) unterschiedlicher Geometrie, wobei die Tubenräder (14) unterschiedlicher Geometrie jeweils einen Antriebskörper (15) und einen Führungskörper (16) aufweisen, die durch mindestens ein Koppelelement (17) miteinander in Wirkverbindung stehen, **dadurch gekennzeichnet, dass** die Koppelelemente (17) der Tubenräder (14) unterschiedlicher Geometrie in der Größe voneinander abweichen.

8. Tubenradsatz nach Anspruch 7, **dadurch gekennzeichnet, dass** sich die durch die Tuben (22) beschriebenen Laufkreise K der Tubenräder (14) unterschiedlicher Geometrie infolge unterschiedlicher Koppelelemente (17) bei Montage der Tubenräder (14) auf derselben, positionsunveränderten Antriebsachse sich in dem Bereich berühren, in welchem der Trennvorgang erfolgt.

9. Tubenradsatz nach Anspruch 7 oder 8, **dadurch gekennzeichnet, dass** die Tubenräder (14) eines Tubenradsatzes unterschiedliche Durchmesser aufweisen, und die Koppelelemente (17) der jeweiligen Tubenräder (14) einen Ausgleichsschenkel (23) unterschiedlicher Länge aufweisen.

10. Tubenradsatz nach einem der Ansprüche 7 bis 9, **dadurch gekennzeichnet, dass** jedes Tubenrad (14) als vorgerüstetes und formatabhängiges Austauschmodul Bestandteil einer Vorrichtung (10) nach einem der Ansprüche 1 bis 6 ist.

## Claims

1. Apparatus (10) for guiding and holding at least one rod (11) of the tobacco-processing industry conveyed continuously in transport direction T during a cutting process of rod-shaped articles (12) from the or each rod (11), comprising a tube wheel (14) which can be driven by means of a drive (13) and is formed from a drive body (15) and a guide body (16) which are operatively connected to one another via at least one coupling element (17), to which is assigned at least one tube (22) as a holding and guide element, wherein the drive body (15) is connected to a drive shaft (18) of the drive (13) in such a manner that the drive body (15) is driven rotationally about axis of rotation A as a stationary and adjustment-free drive axis, and the guide body (16) is mounted on an assembly arm (20) on an axis element (21) in such a manner that the guide body (16) is formed rotationally about an axis of rotation B, which is arranged offset to axis of rotation A, wherein a tube wheel (14) can be exchanged for a different tube wheel (14) for adjustment of the apparatus (10) to changed article lengths which determine the format, **characterised in that** the or each coupling element (17) is formed as a format part in such a manner that the length of the or each coupling element (17) is adapted to the format respectively to be cut so that the exchangeable tube wheels (14) of different geometries with identical length of the tubes (22) have a constant distance H between axis of rotation A and the rod (11) to be cut.

2. Apparatus according to claim 1, **characterised in that** the or each coupling element (17) is formed approximately Z-shaped, wherein the length of a compensation arm (23) of the coupling element (17) is format-dependent.

3. Apparatus according to claim 2, **characterised in that** the length of the compensation arm (23) of the or each coupling element (17) varies with the change in the geometry of the tube wheels (14).

4. Apparatus according to any one of claims 1 to 3, **characterised in that** both the drive body (15) and the guide body (16) are formed as disc-like rotational bodies, wherein the geometry of the tube wheels (14) is defined via the radii of the rotational bodies.

5. Apparatus according to claim 4, **characterised in that** the radii of the two rotational bodies which form the tube wheel (14) are identical for each format, but varying from format to format, wherein resultant difference Δ h can be equalised by the adapted length of the compensation arm (23) of the or each coupling element (17).

6. Apparatus according to any one of claims 1 to 5, **characterised in that** a mounting arm (24) of the coupling element (17) is mounted in the drive body (15), while a different mounting arm (25) of the coupling element (17) is mounted in the guide body (16), wherein the mounting arm (25) mounted in the guide body (16) supports at least one tube (22).

7. Tube wheel set for guiding and holding at least one rod (11) of the tobacco-processing industry conveyed continuously in transport direction T during a cutting process of rod-shaped articles (12) of different formats from the or each rod (11), comprising at least two tube wheels (14) of different geometry which are rotationally drivable about a drive axis which is constant, namely stationary and adjustment-free, in terms of distance H to the rod (11), wherein the tube wheels (14) of different geometry have in each case a drive body (15) and a guide body (16) which are operatively connected to one another by at least one coupling element (17), **characterised in that** the coupling elements (17) of the tube wheels (14) of different geometry deviate from one another in terms of size.

8. Tube wheel set according to claim 7, **characterised in that** running circles K, described by the tubes (22), of the tube wheels (14) of different geometry contact one another in the region in which the separating process takes place as a result of different coupling elements (17) during mounting of the tube wheels (14) on the same drive axis with an unchanged position.

9. Tube wheel set according to claim 7 or 8, **characterised in that** the tube wheels (14) of a tube wheel set have different diameters, and the coupling elements (17) of the respective tube wheels (14) have a compensation arm (23) of a different length.

10. Tube wheel set according to any one of claims 7 to 9, **characterised in that** each tube wheel (14) is a component of an apparatus (10) according to any one of claims 1 to 6 as a pre-fitted and format-dependent exchange module.

## Revendications

1. Dispositif (10) de guidage et de maintien d'au moins un boudin (11), transporté en continu dans la direction de transport T, de l'industrie de transformation du tabac, pendant une opération de coupe d'articles (12) en forme de boudin à partir du ou de chaque boudin (11), comprenant une roue à tubes (14), pouvant être entraînée par un organe d'entraînement (13), qui est formée d'un corps d'entraînement (15) et d'un corps de guidage (16), qui sont reliés par action coordonnée l'un avec l'autre par l'intermédiaire d'au moins un élément d'accouplement (17) auquel au moins un tube (22) est affecté en tant qu'élément de maintien et de guidage, le corps d'entraînement (15) étant relié à un arbre d'entraînement (18) de l'organe d'entraînement (13) de telle sorte que le corps d'entraînement (15) soit entraîné en rotation autour de l'axe de rotation A, servant d'axe d'entraînement fixe et sans possibilité de réglage, et le corps de guidage (16) étant logé contre un bras support (20) sur un élément d'axe (21), de façon telle que le corps de guidage (16) est configuré de façon à tourner autour d'un axe de rotation B qui est disposé d'une manière décalée par rapport à l'axe de rotation A, et une roue à tubes (14) pouvant, pour permettre une adaptation du dispositif (10) à des longueurs d'articles variables, définissant le format, être remplacée par une autre roue à tubes (14), **caractérisé en ce que** le ou chaque élément d'accouplement (17) est conçu comme une pièce définissant le format, de telle sorte que la longueur du ou de chaque élément d'accouplement (17) est adaptée au format respectif à couper, si bien que les roues à tubes (14) remplaçables de différentes géométries présentent pour une longueur identique des tubes (22) une distance constante H entre l'axe de rotation A et le boudin à couper (11).

2. Dispositif selon la revendication 1, **caractérisé en ce que** le ou chaque élément d'accouplement (17) est configuré approximativement en forme de Z, la longueur d'une branche de compensation (23) de l'élément d'accouplement (17) dépendant du format.

3. Dispositif selon la revendication 2, **caractérisé en ce que** la longueur de la branche de compensation (23) du ou de chaque élément d'accouplement (17) varie quand varie la géométrie des roues à tubes (14).

4. Dispositif selon l'une des revendications 1 à 3, **caractérisé en ce que** tant le corps d'entraînement (15) que le corps de guidage (16) sont configurés comme des corps de rotation de type disque, la géométrie des roues à tubes (14) étant définie par l'intermédiaire du rayon des corps de rotation.

5. Dispositif selon la revendication 4, **caractérisé en ce que** les rayons des deux corps de rotation formant la roue à tubes (14) sont identiques pour chaque format, mais varient d'un format à l'autre, la différence Δh qui en résulte pouvant être compensée par la longueur adaptée de la branche de compensation (23) du ou de chaque élément d'accouplement (17).

6. Dispositif selon l'une des revendications 1 à 5, **caractérisé en ce qu'**une branche de support (24) de l'élément d'accouplement (17) est logée dans le corps d'entraînement (15), tandis qu'une autre branche de support (25) de l'élément d'accouplement (17) est logée dans le corps de guidage (16), la branche de support (25) logée dans le corps de guidage (16) portant au moins un tube (22).

7. Jeu de roues à tubes destiné au guidage et au maintien d'au moins un boudin (11), transporté en continu dans la direction de transport T, de l'industrie de transformation du tabac pendant une opération de coupe d'articles (12) en forme de boudin de différents formats à partir du ou de chaque boudin (11), comprenant au moins deux roues à tubes (14) de géométries différentes, pouvant être entraînées en rotation autour d'un axe de rotation constant pour ce qui concerne la distance H au boudin (11), à savoir fixe et sans possibilité de réglage, les roues à tubes (14) de géométries différentes présentant chacune un corps d'entraînement (15) et un corps de guidage (16), qui sont reliés par action coordonnée l'un avec l'autre par l'intermédiaire d'au moins un élément d'accouplement (17), **caractérisé en ce que** les éléments d'accouplement (17) des roues à tubes (14) de géométries différentes diffèrent les uns des autres pour ce qui est de leur taille.

8. Jeu de roues à tubes selon la revendication 7, **caractérisé en ce que** les surfaces de roulement K, décrites par les tubes (22), des roues à tubes (14) de géométries différentes sont, du fait d'éléments d'accouplement (17) différents lors du montage des roues à tubes (14) sur le même axe d'entraînement, dont la position n'a pas été modifiée, en contact dans la zone dans laquelle a lieu l'opération de séparation.

9. Jeu de roues à tubes selon la revendication 7 ou 8, **caractérisé en ce que** les roues à tubes (14) d'un jeu de roues à tubes présentent des diamètres différents, et les éléments d'accouplement (17) des roues à tubes (14) respectifs présentent chacun une branche de compensation (23) de longueur différente.

10. Jeu de roues à tubes selon l'une des revendications 7 à 9, **caractérisé en ce que** chaque roue à tubes (14) est, en tant que module remplaçable, pré-équipé et dépendant du format, un constituant d'un dispositif (10) selon l'une des revendications 1 à 6.
